(19) Europäisches Patentamt
European Patent Office
Office européen des brevets

(11) **EP 3 937 243 A1**

(12) **EUROPEAN PATENT APPLICATION**

(43) Date of publication:
**12.01.2022 Bulletin 2022/02**

(51) Int Cl.:
***H01L 27/146*** (2006.01)

(21) Application number: **21169472.4**

(22) Date of filing: **20.04.2021**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **07.07.2020 US 202063048865 P**
**11.02.2021 US 202117173469**

(71) Applicant: **VisEra Technologies Company Limited Hsinchu 300-78 (TW)**

(72) Inventors:
• **Kuang-Yu, HUANG**
**800 Kaohsiung City (TW)**
• **Wen-Fei, YANG**
**912 Pingtung County (TW)**
• **Huang-Jen, CHEN**
**30078 Hsin-Chu City (TW)**
• **Hao-Min, CHEN**
**302 Hsinchu County (TW)**

(74) Representative: **Ter Meer Steinmeister & Partner Patentanwälte mbB**
**Nymphenburger Straße 4**
**80335 München (DE)**

(54) **IMAGE SENSOR**

(57) An image sensor includes: a substrate; color filter units disposed on the substrate; and a grid structure disposed on the substrate and surrounding each of the color filter units. The grid structure includes: a first partition wall, disposed on the substrate, located between the color filter units; and a second partition wall, disposed directly on the first partition wall, located between the color filter units. A top width of the second partition wall is smaller than a bottom width of the second partition wall.

FIG. 1

**Description**

**BACKGROUND**

**Technical Field**

The present disclosure relates to an image sensor, and it particularly relates to a design for a grid structure of an image sensor.

**Description of the Related Art**

Image sensors, such as complementary metal oxide semiconductor (CMOS) image sensors (also known as CIS), are widely used in various image-capturing apparatuses such as digital still-image cameras, digital video cameras, and the like. The light-sensing units in an image sensor may detect ambient color change, and signal electric charges may be generated depending on the amount of light received by the light-sensing units. In addition, the signal electric charges generated by the light-sensing units may be transmitted and amplified, whereby an image signal is obtained.
To meet industrial demand, pixel size has continuously been reduced, while pixel definition has continuously been enhanced. In order to maintain superior levels of performance, entry light rays should be concentrated within each color filter unit for effective light reception, without interference of light rays from adjacent color filter units. Each color filter unit is compartmentalized by a grid structure, which has a lower refractive index than that of the color filter units. Since light rays tend to be directed toward mediums with higher refractive index, the grid structure can repel potential light rays from interfering adjacent color filter units. However, more innovative ways of designing the grid structure is required to accommodate pixels with continuously shrinking size.

**SUMMARY**

In an embodiment, an image sensor includes: a substrate; color filter units disposed on the substrate; and a grid structure disposed on the substrate and surrounding each of the color filter units. The grid structure includes: a first partition wall, disposed on the substrate, located between the color filter units; and a second partition wall, disposed directly on the first partition wall, located between the color filter units.
Preferably, a top width of the second partition wall may be smaller than a bottom width of the second partition wall.
In another embodiment, an image sensor includes: a substrate; color filter units disposed on the substrate; and a grid structure disposed on the substrate and surrounding each of the color filter units. The grid structure includes: a first partition wall having a vertical side surface relative to the substrate with a base width, disposed on the substrate, located between the color filter units; a second partition wall having an inclined side surface relative to the substrate, disposed directly on the first partition wall, located between the color filter units; and a third partition wall having a first width, disposed directly on the second partition wall, located between the color filter units, wherein the first width is smaller than the base width.
In one or more embodiments a first refractive index of the grid structure may be in a range between 1 and 1.5.
In one or more embodiments, the image sensor may further comprise a third partition wall.
Preferably, the third partition wall may be disposed directly on the second partition wall.
Preferably, the third partition wall may be located between the color filter units.
In one or more embodiments, cross sections of the first partition wall and the third partition wall may be rectangular.
In one or more embodiments, a cross section of the second partition wall may be trapezoidal.
In one or more embodiments, the first partition wall may have a base width.
In one or more embodiments, the third partition wall may have a first width.
In one or more embodiments, the base width and the first width may be measured in a transversal direction parallel to the substrate.
In one or more embodiments, the first width of the third partition wall may be smaller than the base width of the first partition wall by approximately 20% to 60%.
In one or more embodiments, the bottom width of the second partition wall may be equal to the base width of the first partition wall.
In one or more embodiments, the top width of the second partition wall may be equal to the first width of the third partition wall.
In one or more embodiments, the image sensor may further comprise a plurality of sensing units formed within the substrate.
In one or more embodiments, the image sensor may further comprise a light shielding structure embedded within the grid structure.

In one or more embodiments, the image sensor may further comprise a plurality of micro-lenses respectively disposed on the color filter units.

In one or more embodiments, a first height of the first partition wall may be lower than a total height of the grid structure, preferably by approximately 60% to 80%.

In one or more embodiments, a side surface of the second partition wall may have an interior angle of approximately 20° to 75° relative to the substrate.

In one or more embodiments, a cross section of the third partition wall may be half elliptical.

In one or more embodiments, a cross section of the third partition wall may have a rounded side surface and a pointed top.

In one or more embodiments, a top angle of the pointed top may be less than the interior angle of the second partition wall.

In one or more embodiments, the grid structure may further comprise one or more rectangular partition walls and one or more trapezoidal partition walls.

In one or more embodiments, the rectangular partition walls and the trapezoidal partition walls may be alternately arranged over the substrate and between the color filter units.

In one or more embodiments, each of the trapezoidal partition walls may have a bottom width and a top width smaller than the bottom width by approximately 20% to 60%.

In one or more embodiments, the first partition wall may have a first refractive index.

In one or more embodiments, the third partition wall may have a second refractive index.

In one or more embodiments, the first refractive index and the second refractive index may be different.

In one or more embodiments, the second partition wall may have the first refractive index or the second refractive index.

In one or more embodiments, cross sections of the first partition wall and the third partition wall may be rectangular.

In one or more embodiments, a cross section of the second partition wall may be trapezoidal.

In one or more embodiments, a cross section of the third partition wall may be half elliptical.

In one or more embodiments, a cross section of the third partition wall may have a rounded side surface and a pointed top.

In one or more embodiments, the grid structure may further comprise one or more rectangular partition walls and one or more trapezoidal partition walls.

In one or more embodiments, the rectangular partition walls and the trapezoidal partition walls may be alternately arranged over the substrate and between the color filter units.

In one or more embodiments, the rectangular partition walls and the trapezoidal partition walls may further comprise one or more refractive indices different from the first refractive index and the second refractive index.

In one or more embodiments, each of the trapezoidal partition walls may have a bottom width and a top width smaller than the bottom width, preferably by approximately 20% to 60%.

## BRIEF DESCRIPTION OF THE DRAWINGS

The disclosure can be more fully understood from the following detailed description when read with the accompanying figures. It is worth noting that, in accordance with standard practice in the industry, various features are not drawn to scale. In fact, the dimensions of the various features may be arbitrarily increased or reduced for clarity of discussion.

Figure 1 is a cross-sectional view of an image sensor, according to some embodiments of the present disclosure.
Figure 2 is a cross-sectional view of the image sensor, according to other embodiments of the present disclosure.
Figure 3 is a cross-sectional view of the image sensor, according to yet other embodiments of the present disclosure.
Figure 4 is a comparison of quantum efficiency plots between two image sensors, according to some embodiments of the present disclosure.
Figure 5 is a cross-sectional view of the image sensor, according to some embodiments of the present disclosure.
Figure 6 is a cross-sectional view of the image sensor, according to other embodiments of the present disclosure.

## DETAILED DESCRIPTION

The following disclosure provides many different embodiments, or examples, for implementing different features of the subject matter provided. Specific examples of components and arrangements are described below to simplify the present disclosure. These are, of course, merely examples and are not intended to be limiting. For example, a first feature is formed on a second feature in the description that follows may include embodiments in which the first feature and second feature are formed in direct contact, and may also include embodiments in which additional features may be formed between the first feature and second feature, so that the first feature and second feature may not be in direct contact.

It should be understood that additional steps may be implemented before, during, or after the illustrated methods, and some steps might be replaced or omitted in other embodiments of the illustrated methods.

Furthermore, spatially relative terms, such as "beneath," "below," "lower," "on," "above," "upper" and the like, may be used herein for ease of description to describe one element or feature's relationship to other elements or features as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

In the present disclosure, the terms "about," "approximately" and "substantially" typically mean $\pm 20\%$ of the stated value, more typically $\pm 10\%$ of the stated value, more typically $\pm 5\%$ of the stated value, more typically $\pm 3\%$ of the stated value, more typically $\pm 2\%$ of the stated value, more typically $\pm 1\%$ of the stated value and even more typically $\pm 0.5\%$ of the stated value. The stated value of the present disclosure is an approximate value. That is, when there is no specific description of the terms "about," "approximately" and "substantially", the stated value includes the meaning of "about," "approximately" or "substantially".

Unless otherwise defined, all terms (including technical and scientific terms) used herein have the same meaning as commonly understood by one of ordinary skill in the art to which this disclosure belongs. It should be understood that terms such as those defined in commonly used dictionaries should be interpreted as having a meaning that is consistent with their meaning in the context of the prior art and will not be interpreted in an idealized or overly formal sense unless expressly so defined in the embodiments of the present disclosure.

The present disclosure may repeat reference numerals and/or letters in following embodiments. This repetition is for the purpose of simplicity and clarity and does not in itself dictate a relationship between the various embodiments and/or configurations discussed.

The grid structure (or partition grid structure) conventionally separates each color filter unit (of the corresponding sensor unit) from the others, so that incident lights may be converted into the desired color of each sensor unit without being affected by adjacent sensor units. However, the market demands for image sensors with smaller pixel sizes, which indirectly raise the probability for incident light rays within each color filter unit to enter adjacent color filter unit, and this is unwanted. When light rays are not sufficiently received by the sensing unit underlying each color filter unit, the quantum efficiency of the image sensor would be undermined. Furthermore, light interference between the color filter units may also increase cross talk, which compromises the image sensor's overall performance. The present disclosure provides several innovative designs of the grid structure to address the above issues. The grid structure of the present disclosure may concentrate entry light rays within each color filter unit onto the corresponding sensing unit, and thereby enhances quantum efficiency and eliminates cross talk, resulting in an image sensor with more superior performance.

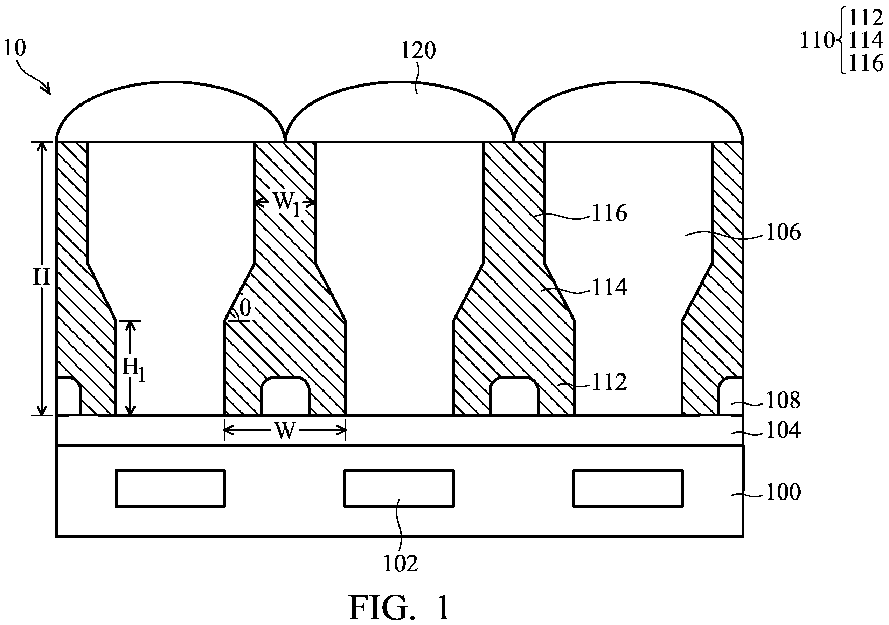

Figure 1 is a cross-sectional view of an image sensor according to some embodiments of the present disclosure. An image sensor may contain millions of sensor units in reality. Figure 1 only displays a portion of an actual image sensor. According to some embodiments of the present disclosure, an image sensor 10 includes a substrate 100, a plurality of sensing units 102, an anti-reflection layer 104, color filter units 106, a light shielding structure 108, a grid structure 110, and a plurality of micro-lenses 120. In the present embodiment, the grid structure 110 includes a first partition wall 112, a second partition wall 114, and a third partition wall 116, which are stacked in sequence. In some embodiments, the first partition wall 112 and the third partition wall 116 have rectangular cross sections, while the second partition wall 114 has a trapezoidal cross section. The first partition wall 112 has a base width W, while the third partition wall 116 has a first width $W_1$. The base width W is larger than the first width $W_1$. Additionally, a bottom width of the second partition wall 114 is equal to the base width W, and a top width of the second partition wall 114 is equal to the first width $W_1$.

Refer to Figure 1. In some embodiments, the image sensor 10 includes a substrate 100. In some embodiments, the substrate 100 may be, for example, a wafer or a chip, but the present disclosure is not limited thereto. In some embodiments, the substrate 100 may be a semiconductor substrate, for example, silicon substrate. Furthermore, in some embodiments, the semiconductor substrate may also be an elemental semiconductor including germanium, a compound semiconductor including gallium nitride (GaN), silicon carbide (SiC), gallium arsenide (GaAs), gallium phosphide (GaP), indium phosphide (InP), indium arsenide (InAs), and/or indium antimonide (InSb), an alloy semiconductor including silicon germanium (SiGe) alloy, gallium arsenide phosphide (GaAsP) alloy, aluminum indium arsenide (AlInAs) alloy, aluminum gallium arsenide (AlGaAs) alloy, gallium indium arsenide (GaInAs) alloy, gallium indium phosphide (GaInP) alloy, and/or gallium indium arsenide phosphide (GaInAsP) alloy, or a combination thereof.

In other embodiments, the substrate 100 may also be a semiconductor on insulator (SOI) substrate. The semiconductor on insulator substrate may include a base plate, a buried oxide layer disposed on the base plate, and a semiconductor layer disposed on the buried oxide layer. Furthermore, the substrate 100 may be an N-type or a P-type conductive type.

In some embodiments, the substrate 100 may include various isolation elements (not shown) to define active regions, and to electrically isolate active region elements within or above the substrate 100. In some embodiments, isolation elements may include shallow trench isolation (STI) elements, local oxidation of silicon (LOCOS) elements, other suitable isolation elements, or a combination thereof. In some embodiments, the formation of the isolation elements may include, for example, forming an insulating layer on the substrate 100, selectively etching the insulating layer and the substrate 100 to form trenches within the substrate 100, growing rich nitrogen-containing (such as silicon oxynitride) liners in the trenches, and filling insulating materials (such as silicon dioxide, silicon nitride, or silicon oxynitride) into the trenches with deposition processes, then performing annealing processes on the insulating materials in the trenches, and performing planarization processes on the substrate 100 to remove excessive insulating materials, so the insulating materials in the trenches are level with the top surface of the substrate 100.

In some embodiments, the substrate 100 may include various P-type doped regions and/or N-type doped regions (not shown) formed of, for example, ion implantation and/or diffusion process. In some embodiments, transistors, photodiodes, or the like, may be formed at the active regions, defined by the isolation elements.

The plurality of sensing units 102 are embedded in the substrate 100. In some embodiments, the plurality of sensing units 102 are photodiodes. Each of the sensing units 102 is configured to sense light and generate an intensity signal according to the intensity of the light falling thereon. The image signal is formed by the intensity signals.

The anti-reflection layer 104 is disposed on the substrate 100. In some embodiments, the anti-reflection layer 104 is configured to decrease the reflection of the light being transmitted to the plurality of sensing units 102. In some embodiments, the anti-reflection layer 104 is disposed horizontally in correspondence (or parallel with respect) to the array of sensing units 102. In some embodiments, the materials of the anti-reflection layer 104 may include $SiO_xN_y$ (wherein x and y are in the range of 0 to 1). The anti-reflection layer 104 may be formed by any suitable deposition processes.

In some embodiments, the image sensor 10 may include color filter units 106 disposed on the anti-reflection layer 104 and the substrate 100, and corresponding to the array of sensing units 102. In some embodiments, the height of the color filter units 106 may be approximately between $0.3\mu m$ and $2.0\mu m$. In some embodiments, the color filter units 106 may be colored red, green, blue, white, or infrared. Each of the color filter units 106 may correspond to each respective sensing unit 102 of the image sensor 10, and the color of the unit depends on the requirement of the image sensor 10. The respective sensing units 102, such as photodiodes, may convert received light signals into electric signals.

In some embodiments, each of the color filter units 106 allows a predetermined range of wavelengths of light to pass through. For example, the red color filter units allow wavelengths of light in a range from 620nm to 750nm (red light) to transmit to the corresponding sensing units 102, the green color filter units allow wavelengths of light in a range from 495nm to 570nm (green light) to transmit to the corresponding sensing units 102, and the blue color filter units allow wavelengths of light in a range from 450nm to 495nm (blue light) to transmit to the corresponding sensing units 102.

Refer to Figure 1. The grid structure 110 is disposed between the color filter units 106. In some embodiments, the grid structure 110 is connected to and around each of the color filter units 106. Moreover, the grid structure 110 is disposed on the anti-reflection layer 104 and the substrate 100, and exposes the areas directly above or compartmentalizes the array of sensing units 102. According to some embodiments of the present disclosure, the grid structure 110 may have a lower refractive index than the color filter units 106. The refractive index is a characteristic of a substance that changes the speed of light, and is a value obtained by dividing the speed of light in vacuum by the speed of light in the substance. When light travels between two different materials at an angle, its refractive index determines the angle of light transmission (refraction). According to some embodiments of the present disclosure, the refractive index of the grid structure 110 is approximately between about 1.0 and about 1.5, while the refractive index of the color filter unit 106 is between about 1.3 and about2.0. Since lights tend to direct toward medium with higher refractive index, the color filter units 106 and the grid structure 110 may form a light pipe structure to guide lights to the plurality of sensing units 102. In other words, when incident light rays enter the color filter units 106, the grid structure 110 may isolate the incident light rays within the specific color filter unit 106 to serve as the light-trapping function.

The material of the grid structure 110 may include a transparent dielectric material. In some embodiments, the materials of the grid structure 110 may include silica ball and air bubble (material doped with inorganic material), or polysiloxane. At first, a grid material layer is coated on the anti-reflection layer 104. Next, a mask layer (not shown) is coated on the grid material layer. In some embodiments, the material of the mask layer is a photoresist. A photolithography process is performed on the mask layer for patterning. Next, an etching process is performed on the grid material layer by using the patterned hard mask layer. The etching process may be dry etching. After the etching process, a portion of the grid material layer is removed on the anti-reflection layer 104, and multiple openings are formed therein. The openings will subsequently be filled with the color filter units 106. According to some embodiments of the present disclosure, multiple photolithography and etching processes may be implemented to form rectangular partition walls (the first partition wall 112 and the third partition wall 116) with different widths. Furthermore, the deposition of material layers with different carbon bonds, followed by etching with etching gas of different fluorine ion concentrations may result into a trapezoidal partition wall (the second partition wall 114).

As mentioned previously, the present embodiment provides an innovative way of designing the grid structure 110. According to some embodiments of the present disclosure, the first width $W_1$ of the third partition wall 116 is smaller than the base width W of the first partition wall 112 by approximately 20% to 60%, for example, approximately 20% to 50%. According to some embodiments of the present disclosure, the base width W and the first width $W_1$ are measured in a transversal direction parallel to the substrate 100. The second partition wall 114 is disposed between the first partition wall 110 and the third partition wall 116. For example, the first partition wall 112 adjoins the bottom of the second partition wall 114, while the third partition wall 116 adjoins the top of the second partition wall 114. According to some embodiments of the present disclosure, a top width of the second partition wall 114 is equal to the first width $W_1$ of the third partition wall 116, while a bottom width of the second partition wall 114 is equal to the base width W of the first partition wall 112. Since the first width $W_1$ of the third partition wall 116 is smaller than the base width W of the first partition wall 112, the top width of the second partition wall 114 is thus smaller than the bottom width of the second partition wall 114. Therefore, the second partition wall 114 has an inclined side surface relative to the substrate 100, so the cross section of the second partition wall 114 appears trapezoidal. The resulting grid structure 110 of the present disclosure has a sidewall that includes both a vertical side surface and an inclined side surface, relative to the substrate 100.

In some embodiments, the light shielding structure 108 may be embedded within the grid structure 110, and the details will be described subsequently. The conventional grid structure has a single rectangular cross section. Due to application requirement, the light shielding structure may sometimes be shifted. In order to accommodate the shift design of the light shielding structure, the grid structure needs to be wide enough. However, if the grid structure becomes too wide, the dimension of the already reduced color filter units may be further compressed. When the color filter units are too small in dimension, the performance of the overall image sensor may be severely affected. By designing the grid structure 110 to have various portions of different width, not only can the process window for the light shielding structure's shift design be improved, the dimension of the color filter units may remain sufficient enough to maintain the performance of the image sensor. Furthermore, the grid structure 110 of the present disclosure causes each of the color filter units 106 to form into a funnel shape. When the incident lights are forced to "funnel" into the color filter units 106, the light rays may be gradually concentrated toward the respective sensing units 102.

As mentioned previously, the grid structure 110 of the present disclosure may enhance quantum efficiency and eliminates cross talk. In some embodiments, the quantum efficiency is the photoelectrical transferring efficiency, which is the measure of how efficient incident lights can be converted into electrical signal. The cross talk is the reading of signal of different light color interfering with the desired light color. In other words, lower quantum efficiency and higher cross talk are unwanted characteristics, as they may affect the performance of image sensors. The grid structure 110 may effectively address the above issues, leading to higher quantum efficiency and less cross talk.

However, if the grid structure 110 only includes multiple rectangular partition walls of different widths stacked together, the grid structure may be in stepped form. When incident lights are transmitted onto the horizontal stepped surface, the light rays may be reflected away from the underlying sensing unit 102. Although such reflection may eliminate cross talk, quantum efficiency may not be improved significantly. Therefore, as shown in Figure 1, using an inclined side surface to connect two vertical side surfaces of different positions may alleviate light-leakage issue, and the waveguide effect in the color filter units 106 and the quantity of light passing through the color filter units 106 are improved. Furthermore, the integration of both the vertical side surface and the inclined side surface may increase the design flexibility of the image sensor 10, to conform to more application demands in the industry.

Refer to Figure 1. The grid structure 110 has a total height H, while the first partition wall 112 has a first height $H_1$. According to some embodiments of the present disclosure, the first height $H_1$ of the first partition wall 112 is lower than the total height H of the grid structure 110 by approximately 60% to 80%, in order to eliminate cross talk, since the cross talk effect may be significantly increased at the edge of the active regions. According to some embodiments of the present disclosure, the inclined side surface of the second partition wall 114 has an interior angle $\theta$ of approximately 20° to 75° relative to the substrate 100, in order to alleviate light-leakage issue. Based on the defined parameters (for example, the base width W, the first width $W_1$, and the interior angle $\theta$), the height of the second partition wall 114 (abbreviated herein as H_114) may be determined by the following equation:

$$H\_114 = \frac{W - W_1}{2} \times \tan\theta \qquad (1)$$

In equation (1), the difference between the base width W and the first width W1 defines how much the first partition wall 112 laterally protrudes beyond opposing sidewalls of the third partition wall 116. Half of that difference then defines how much the first partition wall 112 laterally protrudes beyond from a single side of the third partition wall 116. Based on the trigonometric rules, multiplying the protrusion dimension on the single side by the tangent of the interior angle $\theta$ may

obtain the height of the second partition wall 114.

From equation (1), the height of the third partition wall 116 (abbreviated herein as H_116) may be determined by the following equation:

$$H\_116 = \mathrm{H} - \left[ H_1 + \left( \frac{\mathrm{W} - W_1}{2} \times \tan\theta \right) \right] \qquad (2)$$

In equation (2), the height of the third partition wall 116 can simply be calculated by subtracting the first height H1 and the height of the second partition wall 114 from the total height H of the grid structure 110.

In order to form the second partition wall 114 with inclined surfaces, the inventor exploits various characteristics on chemical reactions between different materials and different etching gas. Initially, the partition material layer may be coated to include various layers with different carbon bonds, the material of these layers may be different. According to some embodiments of the present disclosure, fluorine ions may be introduced into the etcher chamber as strong active gas, in which the fluorine ion concentration may be constantly adjusted throughout the entire etching process. In some embodiments, when fluorine ions come in contact with carbon bonds, a chemical reaction will occur to produce hardened carbon material, which is difficult to be etched.

For example, the carbon bonds of the partition material layer may be arranged to have the highest amount at the bottom, and gradually decrease toward the top, this can be achieved by a consecutive deposition of material layers with a decreasing order of carbon bonds. During etching, the fluorine ion within the active gas may begin at the highest concentration for etching the topmost material layer with the lowest amount of carbon bonds. As the etching proceeds to etching the underlying material layers with increasing carbon bonds, the fluorine ion within the active gas may be correspondingly lowered. Under those conditions, a larger area of the grid material may be etched away at first (from the top) due to less hardened carbon material generated. However, a minimal area of the grid material may be etched away toward the end (at the bottom) due to more hardened carbon material generated. By accurately calculating the fluorine ion concentration and carbon bonds, and precisely controlling the etching time using the material etching rate, the inclined side surface of the second partition wall 114 may be formed. Please note that the amount of carbon bonds does not affect the refractive index of the material of the second partition wall 114.

According to a specific embodiment of the present disclosure for forming the second partition wall 114, approximately 10% to 30% of grid material layers may be sequentially deposited. The bottommost material layer may include air silica ball (material doped with inorganic material), with the carbon bond concentration between about 40% and 80%. The topmost material layer may include polysiloxane, propylene glycol monomethyl ether, 3-methoxy-1-butanol, with the carbon bond concentration between about 20% and 60%. In some embodiments, the etching process may begin from etching the topmost material layer, during which the etching gas may include a fluorine ion concentration between about 15% and 30%. In other embodiments, etching gas of $CH_2F_2$, $CHF_3$, $CH_3F$, $CO_2$, $O_2$, $H_2$, Ar, or the like, or a combination thereof may also be used. When etching the material layer directly underlying the topmost material layer, the fluorine ion concentration may be reduced by approximately 30% to 50%. When etching the bottommost material layer, the fluorine ion concentration may be adjusted to zero.

Refer to Figure 1. The light shielding structure 108 is disposed on the anti-reflection layer 104 and the substrate 100 between the color filter units 106. In some embodiments of the present disclosure, the light shielding structure 108 is in grid form that compartmentalizes each of the color filter units 106. In some embodiments, the light shielding structure 108 is embedded within the grid structure 110. In other words, the light shielding structure 108 is also in grid form that corresponds with the grid structure 110. In some embodiments, the grid structure 110 may be higher than or equal to the light shielding structure 108, depending on the design requirement of the image sensor 10. The arrangement of the light shielding structure 108 may prevent one of the sensing units 102 under the corresponding color filter unit 106 to receive additional light from an adjacent color filter unit 106 of different color, which may affect the accuracy of signals received. In some embodiments of the present disclosure, the height of the light shielding structure 108 may be approximately between $0.005\mu m$ and $2.000\mu m$. In some embodiments, the material of the light shielding structure 114 may include opaque metals (such as tungsten (W), aluminum (Al)), opaque metal nitride (such as titanium nitride (TiN)), opaque metal oxide (such as titanium oxide (TiO)), other suitable materials, or a combination thereof, but the present disclosure is not limited thereto. The light shielding structure 108 may be formed by depositing a metal layer on the substrate 100 and then patterning the metal layer using photolithography and etching processes, but the present disclosure is not limited thereto. In a specific embodiment of the present disclosure, the light shielding structure 108 may be a buried color filter array (BCFA) that includes a tungsten metal wrapped around by aluminum.

Refer to Figure 1. The plurality of micro-lenses 120 are disposed on the color filter units 106 and the grid structure 110. According to some embodiments of the present disclosure, the plurality of micro-lenses 120 may correspond to the plurality of sensing units 102, respectively. In the present embodiment, the plurality of micro-lenses 120 may be arranged in an array parallel to the substrate 100. In some embodiments, the plurality of micro-lenses 120 serve to converge incident light into the plurality of sensing units 102 in the substrate 100 through the color filter units 106. In some embodiments, the material of the plurality of micro-lenses 120 may be a transparent material. For example, the material may include glass, epoxy resin, silicone resin, polyurethane, any other applicable material, or a combination thereof, but the present disclosure is not limited thereto. In some embodiments, the plurality of micro-lenses 120 may be formed by a photoresist reflow method, a hot embossing method, any other applicable method, or a combination thereof. In some embodiments, the steps of forming the plurality of micro-lenses 120 may include a spin-on coating process, a lithography process, an etching process, any other applicable processes, or a combination thereof, but the present disclosure is not limited thereto.

As shown in Figure 1, according to some embodiments, an image sensor 10 of the present disclosure includes: a substrate 100; color filter units 106 disposed on the substrate 100; and a grid structure 110 disposed on the substrate 100 and surrounding each of the color filter units 106. The grid structure 110 includes: a first partition wall 112, disposed on the substrate 100, located between the color filter units 106; a second partition wall 114, disposed directly on the first partition wall 112, located between the color filter units 106; and a third partition wall 116, disposed directly on the second partition wall 114, located between the color filter units 106. A cross section of the first partition wall 112 is rectangular, and a cross section of the second partition wall 114 is trapezoidal, with a top width smaller than a bottom width.

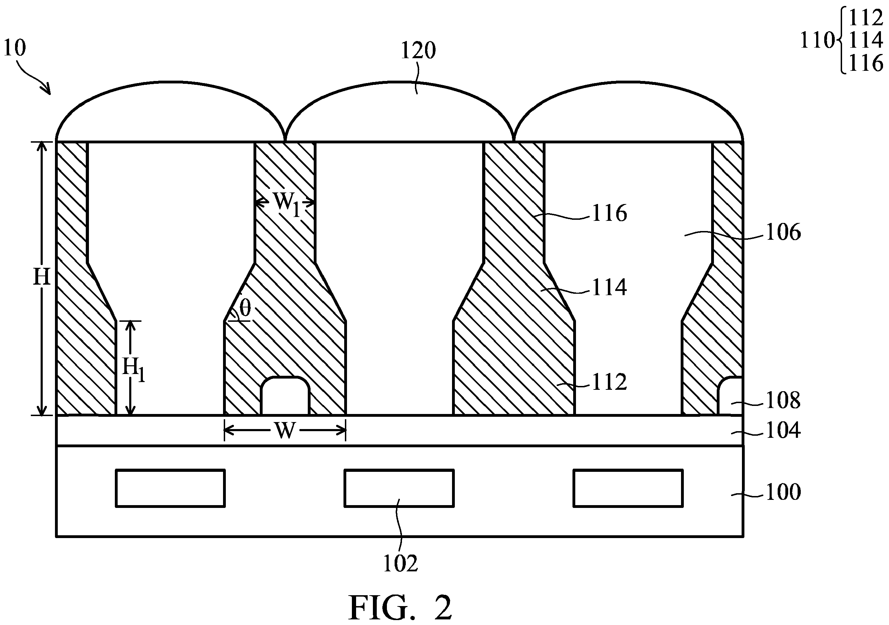

Figure 2 is a cross-sectional view of the image sensor 10, according to other embodiments of the present disclosure. In comparison with Figure 1, Figure 2 illustrates an alternative embodiment of the image sensor 10. The features of the substrate 100, the plurality of sensing units 102, the anti-reflection layer 104, the color filter units 106, the light shielding structure 108, the grid structure 110, and the plurality of micro-lenses 120 are similar to those illustrated in Figure 1, and the details are not described again herein to avoid repetition. The light shielding structure 108 in Figure 2 does not completely correspond with the grid structure 110. For example, the light shielding structure 108 may be embedded in some portions of the grid structure 110, while the light shielding structure 108 may not be present in other portions of the grid structure 110. In some embodiments, the light shielding structure 108 may be embedded in only some portions of the grid structure, or may be entirely missing from the image sensor 10, depending on the design requirement. As illustrated in Figure 2, when two or more adjacent color filter units 106 are of the same color, or when one sensing unit 102 may cover a significantly larger area than an adjacent sensing unit 102, the light shielding structure 108 may be omitted in some portions of the grid structure 110.

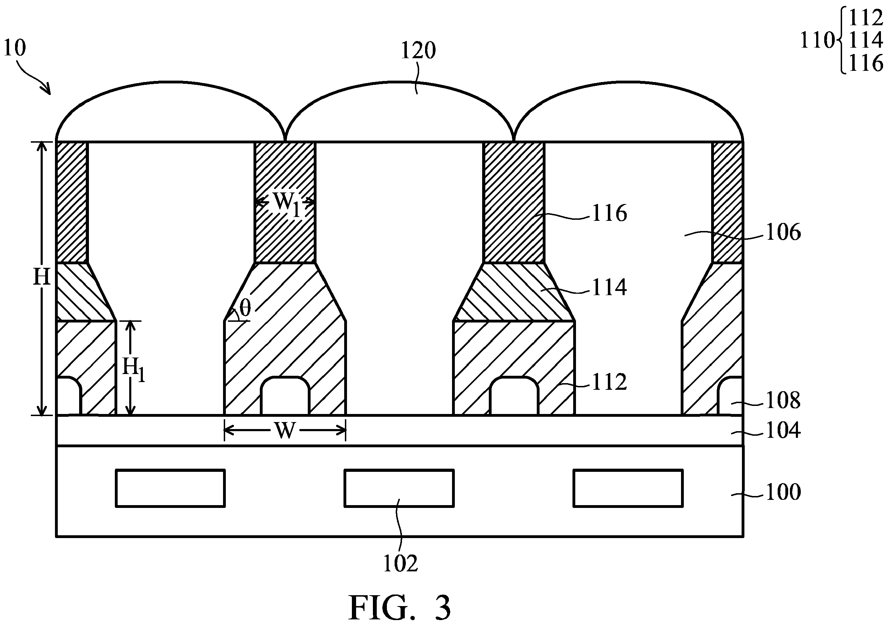

Figure 3 is a cross-sectional view of the image sensor 10, according to yet other embodiments of the present disclosure. In comparison with Figure 1, Figure 3 illustrates an alternative embodiment of the image sensor 10. The features of the substrate 100, the plurality of sensing units 102, the anti-reflection layer 104, the color filter units 106, the light shielding structure 108, the grid structure 110, and the plurality of micro-lenses 120 are similar to those illustrated in Figure 1, and the details are not described again herein to avoid repetition. In Figure 1 and Figure 2, the entire grid structure 110 is form by materials of the same refractive index. The image sensor 10 shown in Figure 3 illustrates that the grid structure 110 may include materials with more than one refractive index. According to some embodiments of the present disclosure, the first partition wall 112 has a first refractive index $n_1$, while the third partition wall 116 has a second refractive index $n_2$. In the present embodiment, the second partition wall 114 may have the first refractive index $n_1$ (same as the first partition wall 112), or the second partition wall 114 may have the second refractive index $n_2$ (same as the third partition wall 116). In some embodiments, the second partition wall 114 may even have yet another refractive index different from the first refractive index $n_1$ and the second refractive index $n_2$, but the present disclosure is not limited thereto. Please note that, the difference in refractive indices does not depend on the materials. For example, the first partition wall 112, the second partition wall 114, and the third partition wall 116 may be formed of different materials, but still have the same refractive indices.

As shown in Figure 3, according to some embodiments, an image sensor 10 of the present disclosure includes: a substrate 100; color filter units 106 disposed on the substrate 100; and a grid structure 110 disposed on the substrate 100 and surrounding each of the color filter units 106. The grid structure 110 includes: a first partition wall 112 having a vertical side surface relative to the substrate 100 with a base width W, disposed on the substrate 100, located between the color filter units 106; a second partition wall 114 having an inclined side surface relative to the substrate 100, disposed directly on the first partition wall 112, located between the color filter units 106; and a third partition wall 116 having a first width $W_1$, disposed directly on the second partition wall 114, located between the color filter units 106, wherein the first width $W_1$ is smaller than the base width W. The first partition wall 112 has a first refractive index $n_1$, and the third partition wall 116 has a second refractive index $n_2$, wherein the first refractive index $n_1$ and the second refractive index $n_2$ are different.

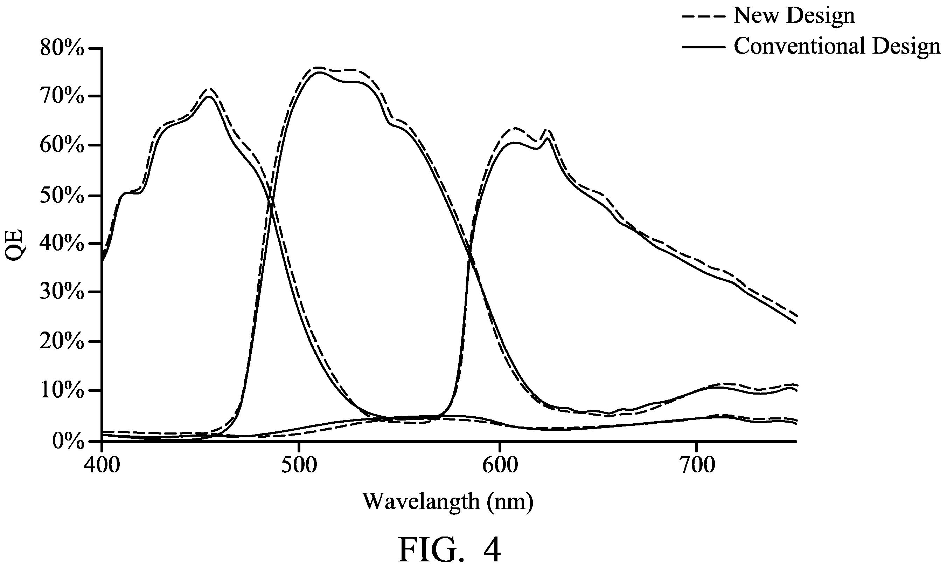

Figure 4 is a comparison of quantum efficiency plots between a conventional image sensor and the image sensor 10 shown in Figure 3, according to some embodiments of the present disclosure. In some embodiments, the conventional image sensor includes a grid structure with single rectangular partition wall of the same material. As mentioned previously, red light has a wavelength from 620nm to 750nm, green light has a wavelength from 495nm to 570nm, and blue light has a wavelength from 450nm to 495nm. As shown in Figure 4, the plots illustrate that the sensitivity and the cross talk of the image sensor 10 shown in Figure 3 of the present disclosure are significantly improved according to the Quantum Efficiency spectrum. In a specific embodiment of the present disclosure, the red light peak of the image sensor 10 is increased by about 2% in comparison with the conventional image sensor, the green light peak of the image sensor 10 is increased by about 1% in comparison with the conventional image sensor, and the blue light peak of the image sensor 10 is increased by about 1% in comparison with the conventional image sensor. In addition, the cross talk of the image sensor 10 is decreased by about 0.6% in comparison with the conventional image sensor. The summary of the comparison data obtained from simulation is shown in Table 1.

Table 1

| Item | Simulation Parameter | | Conventional Design | Image Sensor 10 |
|---|---|---|---|---|
| 1 | Quantum Efficiency Peak | Green Light | 75% | 76% |
| 2 | | Red Light | 62% | 64% |
| 3 | | Blue Light | 70% | 71% |
| 4 | Cross Talk | | 8.1% | 7.5% |
| 5 | Cross Talk Ratio (B/R @ 530nm) | | 6.3/4.6 | 5.8/3.7 |
| 6 | Cross Talk Ratio (B/G @ 650nm) | | 2.4/6.0 | 2.4/5.6 |

In Table 1, Items 1-3 are the quantum efficiency peak data of red light, green light, and blue light, respectively. Items 4-6 are cross talk data, in which the image sensor 10 illustrates significantly reduced cross talk in comparison with the conventional image sensor. In Item 5, the ratio of blue light cross talk and red light cross talk is measured at 530nm. Please note that, 530nm is in a wavelength range where the green light belongs, thus in an ideal situation, the blue light and the red light readings should not exist. In Item 6, the ratio of blue light cross talk and green light cross talk is measured at 650nm. Please note that, 650nm is in a wavelength range where the red light belongs, thus in an ideal situation, the blue light and the green light readings should not exist. Therefore, a reduced cross talk can improve the overall performance, as the image sensor 10 displays. Please also note that, the green color filter units often occupies about 50% of an entire image sensor, while the red color filter units and the blue color filter units each occupies about 25% of the entire image sensor. On that basis, the green color filter units may be affected by the red light cross talk and the blue light cross talk the most, as shown in Item 5 of Table 1.

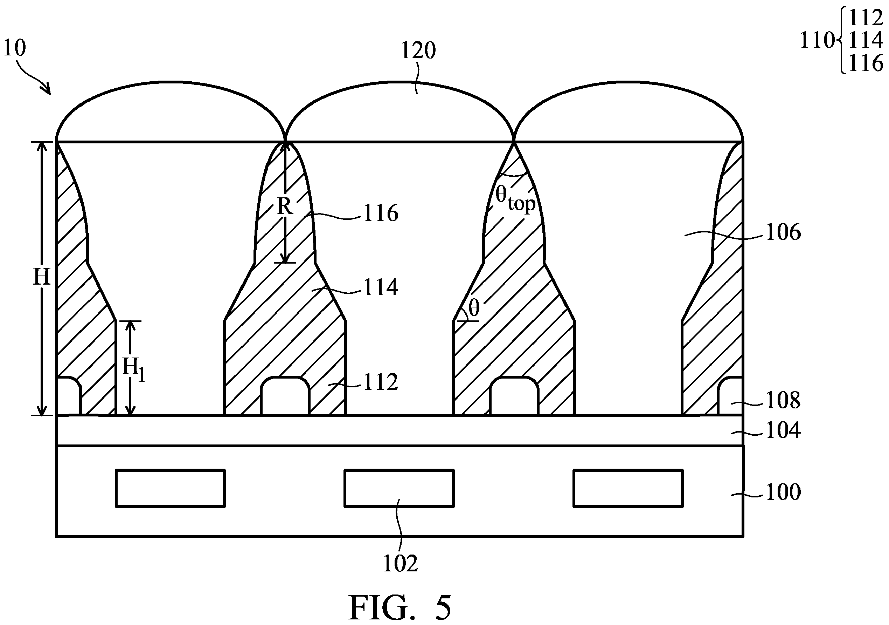

Figure 5 is a cross-sectional view of the image sensor 10, according to some embodiments of the present disclosure. In comparison with Figure 1, Figure 5 illustrates an alternative embodiment of the image sensor 10. The features of the substrate 100, the plurality of sensing units 102, the anti-reflection layer 104, the color filter units 106, the light shielding structure 108, the grid structure 110, and the plurality of micro-lenses 120 are similar to those illustrated in Figure 1, and the details are not described again herein to avoid repetition. The third partition wall 116 of the grid structure 110 in the image sensor 10 shown in Figure 5 is not rectangular. For example, the third partition wall 116 may have rounded side surfaces. The top of the third partition wall 116 may be rounded (continued from the rounded side surfaces) or pointed (triangular form), but the present disclosure is not limited thereto.

Refer to Figure 5. When the third partition wall 116 includes rounded side surfaces and a rounded top, the cross section of which may appear similar to a half elliptical shape with a lengthwise elliptical radius R. According to some embodiments of the present disclosure, the lengthwise elliptical radius R shown in Figure 5 may be equal to or less than the height of the third partition wall 116, and the dimension of which is measured in equation (2). Depending on the first width $W_1$ and the etching condition, the third partition wall 116 may include rounded side surfaces and a pointed top with a top angle $\theta_{top}$. In some embodiments, the top angle $\theta_{top}$ is less than the interior angle $\theta$ of the second partition wall 114. According to some embodiments of the present disclosure, the top angle $\theta_{top}$ may be determined by the following equation:

$$\theta_{top} < 2 \times \tan^{-1}\left(\frac{W_1}{2 \times \left\{H - \left[H_1 + \left(\frac{W - W_1}{2} \times \tan\theta\right)\right]\right\}}\right) \qquad (3)$$

In equation (3), it can be noted that the formula in the braces (displayed as "{}") within the inverse tangent parenthesis is in fact the content of equation (2), or the calculation of the height of the third partition wall 116. The inverse tangent of the ratio of half the first width $W_1$ and the height of the third partition wall 116, followed by a multiplication of 2 may result in an upper limit of the top angle $\theta_{top}$, or a final value larger than the top angle $\theta_{top}$.

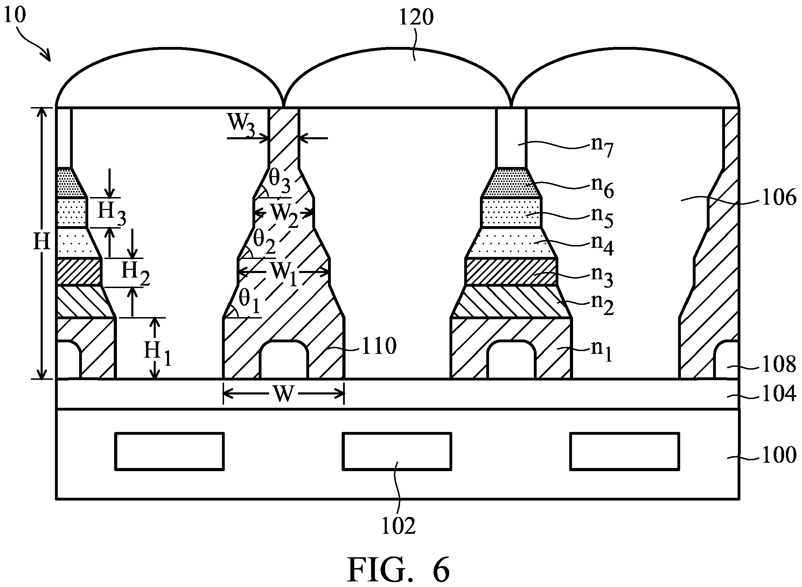

Figure 6 is a cross-sectional view of the image sensor 10, according to other embodiments of the present disclosure. In comparison with Figure 1, Figure 6 illustrates an alternative embodiment of the image sensor 10. The features of the substrate 100, the plurality of sensing units 102, the anti-reflection layer 104, the color filter units 106, the light shielding structure 108, the grid structure 110, and the plurality of micro-lenses 120 are similar to those illustrated in Figure 1, and the details are not described again herein to avoid repetition. It can be noted that the grid structure 110 in the image sensor 10 shown in Figure 6 includes more than three partition walls. Please be aware that, even though the light shielding structure 108 are disposed within the bottom partition wall of the grid structure 110 as illustrated, the light shielding structure 108 may also extend into more than one partition walls. In other words, the configuration of the light shielding structure 108 is independent from that of the grid structure 110, as long as the light shielding structure 108 is embedded within the grid structure 110. Please also note that, like the image sensor 10 shown in Figure 3, the grid structure 110 may include partition walls with different refractive indices. According to some embodiments of the present disclosure, the grid structure 110 may include materials of up to 10 different refractive indices, or up to 8 more refractive indices besides the first refractive index $n_1$ and the second refractive index $n_2$ (for example: $n_3$, $n_4$, $n_5$... $n_{10}$). According to some embodiments of the present disclosure, all refractive indices of the grid structure 110 is approximately between about 1.0 and about 1.5.

Refer to Figure 6. Even though the grid structure 110 appears to be more sophisticated than that shown in Figure 1, they are both bounded by several basic principles. For example, rectangular partition walls and trapezoidal partition walls are alternately arranged over the substrate 100 and between the color filter units 106. According to some embodiments of the present disclosure, every trapezoidal partition walls has a bottom width that is equal to the width of the rectangular partition wall adjoining from below, and a top width is equal to the width of the rectangular partition wall adjoining from above. In every trapezoidal partition wall, the top width is smaller than the bottom width by approximately 20% to 60%, for example, approximately 20% to 50%. In other words, the rectangular partition wall above each trapezoidal partition wall is narrower than the rectangular partition wall below that trapezoidal partition wall by approximately 20% to 60%, for example, approximately 20% to 50%. For example, as shown in Figure 6, the first width $W_1$ is smaller than the base width W by approximately 20% to 60% (for example, approximately 20% to 50%), the second width $W_2$ is smaller than the first width $W_1$ by approximately 20% to 60% (for example, approximately 20% to 50%), and the third width $W_3$ is smaller than the second width $W_2$ by approximately 20% to 60% (for example, approximately 20% to 50%). According to some embodiments of the present disclosure, the grid structure 110 may include as many as 11 rectangular partition walls (for example: with widths of W, $W_1$, $W_2$, $W_3$... $W_{10}$), with trapezoidal partition walls alternating in between. According to some embodiments of the present disclosure, the height of each rectangular partition wall is lower than the total height H of the grid structure 110 by approximately 60% to 80%.

Refer to Figure 6. Since there can be up to a total of 11 rectangular partition walls within the grid structure 110, there can be as many as 10 trapezoidal partition walls alternating between these rectangular partition walls. The trapezoidal partition walls may each has an interior angle $\theta$ of approximately 20° to 75° (for example: $\theta_1$, $\theta_2$, $\theta_3$...$\theta_{10}$). Based on the defined parameters (for example, the top width and the bottom width of each trapezoidal partition wall, and the interior angle $\theta$), the height of the corresponding trapezoidal partition wall may be determined, with reference to equation (1). Please be aware that the reduced rates from the base width W to the first width $W_1$, from the first width $W_1$ to the second width $W_2$, or from the second width $W_2$ to the third width $W_3$ can be the same or different, and do not have to be in increasing order or decreasing order from the substrate 100. Please note that, when the widths of the rectangular partition walls are reduced to a certain extent, the topmost rectangular partition wall may eventually result into a rounded top or a pointed top (as illustrated in Figure 5). Similarly, the interior angles $\theta_1$, $\theta_2$, and $\theta_3$ of the trapezoidal partition walls can be the same or different, and do not have to be in increasing order or decreasing order from the substrate 100. The heights $H_1$, $H_2$, and $H_3$ of the rectangular partition walls can be the same or different, and do not have to be in increasing order or decreasing order from the substrate 100.

The foregoing outlines features of several embodiments so that those skilled in the art will better understand the aspects of the present disclosure. Those skilled in the art should appreciate that they may readily use the present disclosure as a basis for designing or modifying other processes and structures for carrying out the same purposes and/or achieving the same advantages of the embodiments introduced herein. Those skilled in the art should also realize that such equivalent constructions do not depart from the spirit and scope of the present disclosure, and that they may make various changes, substitutions, and alterations herein without departing from the spirit and scope of the present disclosure. Therefore, the scope of protection should be determined through the claims. In addition, although some embodiments of the present disclosure are disclosed above, they are not intended to limit the scope of the present disclosure.

Reference throughout this specification to features, advantages, or similar language does not imply that all of the features and advantages that may be realized with the present disclosure should be or are in any single embodiment of the disclosure. Rather, language referring to the features and advantages is understood to mean that a specific feature, advantage, or characteristic described in connection with an embodiment is included in at least one embodiment of the present disclosure. Thus, discussions of the features and advantages, and similar language, throughout this specification may, but do not necessarily, refer to the same embodiment.

Furthermore, the described features, advantages, and characteristics of the disclosure may be combined in any suitable manner in one or more embodiments. One skilled in the prior art will recognize, in light of the description herein, that the disclosure can be practiced without one or more of the specific features or advantages of a particular embodiment. In other instances, additional features and advantages may be recognized in certain embodiments that may not be present in all embodiments of the disclosure.

**Claims**

1. An image sensor, comprising:

    a substrate (100);
    color filter units (106) disposed on the substrate (100); and
    a grid structure (110) disposed on the substrate (100) and surrounding each of the color filter units (106), wherein the grid structure (110) comprises:

        a first partition wall (112), disposed on the substrate (100), located between the color filter units (106); and
        a second partition wall (114), disposed directly on the first partition wall (112), located between the color filter units (106).

2. The image sensor of claim 1, wherein a top width of the second partition wall (114) is smaller than a bottom width of the second partition wall (114).

3. The image sensor of claim 1 or 2, wherein a first refractive index ($n_1$) of the grid structure (110) is in a range between 1 and 1.5.

4. The image sensor of claim 1, 2 or 3, further comprises a third partition wall (116), disposed directly on the second partition wall (114), located between the color filter units (106), preferably cross sections of the first partition wall (112) and the third partition wall (116) are rectangular, and a cross section of the second partition wall (114) is trapezoidal.

5. The image sensor of claim 4, wherein the first partition wall (112) has a base width (W), and the third partition wall (116) has a first width ($W_1$), wherein the base width (W) and the first width ($W_1$) are measured in a transversal direction parallel to the substrate (100), wherein the first width ($W_1$) of the third partition wall (116) is smaller than the base width (W) of the first partition wall (112) by approximately 20% to 60%.

6. The image sensor of claim 5, wherein the bottom width of the second partition wall (114) is equal to the base width (W) of the first partition wall (112), and the top width of the second partition wall (114) is equal to the first width ($W_1$) of the third partition wall (116).

7. The image sensor of any one of the preceding claims, further comprises at least one of:

    a plurality of sensing units (102) formed within the substrate (100),
    a light shielding structure (108) embedded within the grid structure (110), and
    a plurality of micro-lenses (120) respectively disposed on the color filter units (106).

8. The image sensor of any one of the preceding claims, wherein a first height ($H_1$) of the first partition wall (112) is lower than a total height (H) of the grid structure (110), preferably by approximately 60% to 80%.

9. The image sensor of any one of the preceding claims, wherein a side surface of the second partition wall (114) has an interior angle ($\theta$) of approximately 20° to 75° relative to the substrate (100).

10. The image sensor of any one of the preceding claims 3-9, wherein a cross section of the third partition wall (116) is half elliptical and/or a cross section of the third partition wall (116) has a rounded side surface and a pointed top, preferably a top angle ($\theta_{top}$) of the pointed top is less than the interior angle ($\theta$) of the second partition wall (114).

11. The image sensor of any one of the preceding claims, wherein the grid structure (110) further comprises one or more rectangular partition walls and one or more trapezoidal partition walls, wherein the rectangular partition walls and the trapezoidal partition walls are alternately arranged over the substrate (100) and between the color filter units (106), wherein each of the trapezoidal partition walls has a bottom width and a top width smaller than the bottom width by approximately 20% to 60%.

12. The image sensor of any one of the preceding claims, wherein the first partition wall (112) and the third partition wall (116) have a vertical side surface relative to the substrate (100); and/or
the second partition wall (114) has an inclined side surface relative to the substrate (100).

13. The image sensor of claim 12, wherein the first partition wall (112) has a first refractive index ($n_1$), and the third partition wall (116) has a second refractive index ($n_2$), wherein the first refractive index ($n_1$) and the second refractive index ($n_2$) are different, wherein the second partition wall (114) has the first refractive index ($n_1$) or the second refractive index ($n_2$), wherein cross sections of the first partition wall (112) and the third partition wall (116) are rectangular, and a cross section of the second partition wall (114) is trapezoidal.

14. The image sensor of claim 12 or 13, wherein a cross section of the third partition wall (116) is half elliptical, wherein a cross section of the third partition wall (116) has a rounded side surface and a pointed top.

15. The image sensor of any one of the preceding claims, wherein the grid structure (110) further comprises one or more rectangular partition walls and one or more trapezoidal partition walls, wherein the rectangular partition walls and the trapezoidal partition walls are alternately arranged over the substrate (100) and between the color filter units (106), wherein the rectangular partition walls and the trapezoidal partition walls further comprise one or more refractive indices different from the first refractive index ($n_1$) and the second refractive index ($n_2$), wherein each of the trapezoidal partition walls has a bottom width and a top width smaller than the bottom width by approximately 20% to 60%.

FIG. 1

EP 3 937 243 A1

FIG. 2

EP 3 937 243 A1

FIG. 3

EP 3 937 243 A1

FIG. 4

FIG. 5

EP 3 937 243 A1

FIG. 6

EP 3 937 243 A1

Europäisches
Patentamt

European
Patent Office

Office européen
des brevets

# EUROPEAN SEARCH REPORT

**Application Number**

EP 21 16 9472

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2017/025458 A1 (LIN KUO-FENG [TW] ET AL) 26 January 2017 (2017-01-26) * paragraphs [0034] - [0047], [0067] - [0073]; figures 1,2,5,6,7,9 * ----- | 1-15 | INV. H01L27/146 |
| A | US 2019/267420 A1 (LEE KYOUNG-IN [KR]) 29 August 2019 (2019-08-29) * figures 3G, 3H, 6D * ----- | 1-15 | |

**TECHNICAL FIELDS SEARCHED (IPC)**

H01L

The present search report has been drawn up for all claims

| Place of search | Date of completion of the search | Examiner |
|---|---|---|
| The Hague | 5 October 2021 | Cabrita, Ana |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

             

& : member of the same patent family, corresponding document

EPO FORM 1503 03.82 (P04C01)

**EP 3 937 243 A1**

## ANNEX TO THE EUROPEAN SEARCH REPORT
## ON EUROPEAN PATENT APPLICATION NO.

EP 21 16 9472

05-10-2021

| Patent document cited in search report | | Publication date | Patent family member(s) | | Publication date |
|---|---|---|---|---|---|
| US 2017025458 | A1 | 26-01-2017 | CN | 106373970 A | 01-02-2017 |
| | | | JP | 6198860 B2 | 20-09-2017 |
| | | | JP | 2017028241 A | 02-02-2017 |
| | | | TW | 201705457 A | 01-02-2017 |
| | | | US | 2017025458 A1 | 26-01-2017 |
| US 2019267420 | A1 | 29-08-2019 | CN | 110197832 A | 03-09-2019 |
| | | | KR | 20190102381 A | 04-09-2019 |
| | | | TW | 201937207 A | 16-09-2019 |
| | | | US | 2019267420 A1 | 29-08-2019 |
| | | | US | 2021272997 A1 | 02-09-2021 |

EPO FORM P0459

For more details about this annex : see Official Journal of the European Patent Office, No. 12/82